Europäisches Patentamt

European Patent Office

Office européen des brevets

(19)

(11) Veröffentlichungsnummer : **0 082 103**
**B1**

(12)

# EUROPÄISCHE PATENTSCHRIFT

(45) Veröffentlichungstag der Patentschrift :
16.04.86

(21) Anmeldenummer : 82710051.2

(22) Anmeldetag : 27.10.82

(51) Int. Cl.⁴ : **H 02 H 7/28**, G 01 R 31/08

(54) **Verfahren und Durchführungsanordnung zur Erfassung von Erdschlüssen in einem elektrischen Energieverteilungsnetz.**

(30) Priorität : **02.11.81 SE 8106436**

(43) Veröffentlichungstag der Anmeldung :
**22.06.83 Patentblatt 83/25**

(45) Bekanntmachung des Hinweises auf die Patenterteilung : **16.04.86 Patentblatt 86/16**

(84) Benannte Vertragsstaaten :
**CH DE FR GB LI**

(56) Entgegenhaltungen :
**DE-A- 2 162 414
DE-B- 2 247 746
GB-A- 2 008 345
US-A- 4 234 901**

(73) Patentinhaber : **ASEA AB**

**S-721 83 Västeras (SE)**

(72) Erfinder : **Berggren, Jan
Bronsfartsgatan 11
S-421 63 Västra Frölunda (SE)**

(74) Vertreter : **Boecker, Joachim, Dr.-Ing.
Rathenauplatz 2-8
D-6000 Frankfurt a.M. 1 (DE)**

## Beschreibung

Die Erfindung betrifft ein Verfahren zur Erfassung von Erdschlüssen in einem elektrischen Energieverteilungsnetz gemäß dem ersten Teil des Anspruches 1 sowie eine Anordnung zur Durchführung des Verfahrens.

Radial (sternförmig) gespeiste Verteilernetze müssen in solcher Weise gegen Erdschlüsse geschützt werden, daß der fehlerhafte Anlagenteil oder die fehlerhafte Leitung automatisch mit Hilfe eines zugehörigen Schalters abgeschaltet wird.

Die Ausführung eines Erdschlußschutzes wird im wesentlichen von der Größe des Netzes, der Art seiner Erdung und von den Vorschriften bestimmt, die für elektrische Starkstromanlagen hinsichtlich der bei Erdschluß an einem schutzgeerdeten Anlagenteil zulässigen Spannungen gelten. Aufgrund des unterschiedlichen Aufbaus der Netze werden deshalb z. Zt. verschiedene Arten von Meßkriterien verwendet.

Die folgenden Bezeichnungen und Benennungen werden im nachstehenden Text verwendet :

$X_C$ = die kapazitive Reaktanz des Netzes gegen Erde in [$\Omega$/Phase]

$X_N$ = die Reaktanz der Nullpunktdrossel in [$\Omega$]

$R_o$ = der Wirkwiderstand der Nullpunktdrossel in [$\Omega$]

$U_o$ = die Nullpunktspannung des Netzes in [V]

$U$ = die Phasenspannung des Netzes in [V]

$(U_o/U) \times 100$ = der Ausbildungsgrad des Erdschlusses in [%]

$I_J$ = der Erdschlußstrom des Netzes in [A]

$I_{JR}$ = der mit der Nullpunktspannung. $U_o$ in Phase liegende Komponente des Erdschlußstromes in [A]

$\hat{I}_{JR}$ = der Spitzenwert von $I_{JR}$ in [A]

$\Delta I_J$ = die Änderung des Erdschlußstroms des Netzes in [A]

$R_F$ = der Übergangswiderstand gegen Erde an der Fehlerstelle in [$\Omega$].

Wie bereits erwähnt, erfolgt das Erfassen von Erdschlüssen auf verschiedene Weise, was u. a. davon abhängt, ob und wie das Netz geerdet ist.

Ein nicht geerdetes Netz, bei dem also der Wirkwiderstand $R_N$ und der Blindwiderstand $X_N$ des Nullpunktes praktisch unendlich sind, kann dann vorkommen, wenn die gesamte Leitungslänge des Netzes nicht allzu groß ist. Der Erdschlußstrom wird hierbei durch den kapazitiven Blindwiderstand $X_C$ des Netzes gegen Erde und den eventuell vorhandenen Übergangswiderstand $R_F$ an der Fehlerstelle begrenzt. In solchen Netzen verwendet man Überstromrichtungsrelais, die auf Erdschlußströme ansprechen, die in Bezug auf die Nullpunktspannung kapazitiv sind.

Eine direkte Erdung, bei der also $R_N = X_N = O$ ist, kommt bei Verteilernetzen außerordentlich selten vor, da der Erdschlußstrom $I_J$ hierbei sehr hohe Werte annehmen würde. Da bei der Direkterdung die Nullpunktspannung $U_o$ Null ist, wird nur der Erdschlußstrom für eine selektive Erfassung oder Abschaltung der fehlerhaften Leitung benutzt.

Eine Erdung über einen Nullpunktwiderstand $R_N$, der größer als 50 Ohm ist, kommt nur in kleineren und mittelgroßen Netzen vor. Der Nullpunktwiderstand $R_N$ wird so gewählt, daß man einen ausreichend großen Wirkstrom, der also mit der Nullpunktspannung in Phase liegt, bei Erdschlüssen erhält. Das Netz wird durch Überstromrichtungsrelais geschützt, die auf ohmschen Erdschlußstrom ansprechen und die mit dem über den Nullpunktwiderstand fließenden Strom gespeist werden.

Erdung mit einer Nullpunktdrossel $X_N$ und einem Nullpunktwiderstand $R_N$ kommt in größeren Netzen vor, in denen der kapazitive Erdschlußstrom sonst zu hoch werden würde. Der kapazitive Erdschlußstrom wird durch die Nullpunktdrossel so kompensiert, daß man ein abgestimmtes Netz erhält. Zur selektiven Fortschaltung des Anlagenteils, in dem ein Erdschluß aufgetreten ist, werden Überstromrichtungsrelais verwendet, die auf ohmschen Erdschlußstrom, d. h. den durch den Nullpunktwiderstand fließenden Strom, ansprechen. Manchmal ist eine besondere Automatik vorhanden, welche die Ein- und Ausschaltung des Nullpunktwiderstandes besorgt, so daß man zunächst einen Versuch zur Selbstlöschung des Erdschlußstroms vornehmen kann, bevor ein Relais anspricht und die Leitung abgeschaltet wird.

Eine Erdung über eine Nullpunktdrossel $X_N$ kommt in sehr großen Netzen vor. Im übrigen gilt dasselbe wie für die Erdung mit einem Widerstand und einer Drossel, doch wird vorausgesetzt, daß der innere Wirkwiderstand $R_o$ der Nullpunktdrossel groß genug ist, um eine Wirkstromkomponente zu erzeugen, die sich auswerten läßt.

Die Anordnungen oder Systeme zur Erdschlußmessung, Identifizierung und Fortschaltung, die z. Zt. verwendet werden, können, wie teilweise aus Vorgesagtem hervorgeht, aufgrund verschiedener Erdungsprinzipien nicht gleich ausgeführt werden. Auch können die gewünschte Empfindlichkeit und Schnelligkeit mit ihnen nicht erreicht werden.

In direkt geerdeten Netzen kann theoretisch zwar eine verhältnismäßig hohe Empfindlichkeit für die Erdschlußschutzvorrichtungen mit der Möglichkeit einer selektiven Erfassung von Fehlern mit hohem Übergangswiderstand erreicht werden. Wegen der sehr hohen Erdschlußströme, die hier auftreten können, kommt diese Erdung, wie bereits erwähnt, jedoch nicht häufig vor.

Nicht geerdete Netze bieten ebenfalls verhältnismäßig gute Möglichkeiten für eine selektive Erfassung von Erdschlüssen mit einem hohen Übergangswiderstand. Nicht geerdete Netze sind jedoch selten, da sie nur für kleine Netze in Betracht kommen. Außerdem möchte man meistens nicht geerdete Netze wegen der Gefahr intermittierender Erdschlüsse vermeiden.

In Netzen, deren Nullpunkt über einen Nullpunktwiderstand $R_N$ geerdet ist, der einem Erdschlußstrom von 2-15 A entspricht, sowie in Netzen mit Erdungsdrossel zusammen mit Widerstanderdung bewirken Überstromrichtungsrelais, die auf Erdschlußwirkströme ansprechen, eine variierende Empfindlichkeit für Erdschlüsse mit einem hohen Übergangswiderstand. Die Empfindlichkeit beruht zum großen Teil auf der Größe des Netzes. Allgemein kann jedoch gesagt werden, daß große Netze begrenzte Möglichkeiten zu einer guten selektiven Erfassung von hochohmigen Erdschlüssen bieten.

Die drei wichtigsten Gründe für die begrenzte Empfindlichkeit von Überstromrichtungsrelais, die auf Erdschlußwirkströme ansprechen, sind folgende :

Bei niedrigen Erdschlußströmen, bei welchen die kapazitive oder die induktive Komponente dominierend ist, kann der Winkelfehler des Stromtransformators eine Fehlmessung verursachen.

Bei Fehlern mit niedrigem Ausbildungsgrad haben Leistungs- und Überstromrichtungsrelais Schwierigkeiten, I × cos φ bei großem φ, d. h. in dem Bereich von φ zwischen 80°-90°, zu messen.

Aus praktischen Gründen kann man die Empfindlichkeit der Relais nicht beliebig hoch einstellen. Dies kann mehrere Gründe haben, wie z. B. Kriechströme an Isolatoren, spontane Kontakte mit der Vegetation oder Salzstürme in der Nähe von Meeresküsten. Eine zu hohe Empfindlichkeit des Erdschlußschutzes würde daher zu ungewollten Abschaltungen führen.

Bei den elektrischen Energieversorgungsunternehmen besteht ein starker Wunsch, Erdschlüsse mit einem höheren Übergangswiderstand $R_F$ an der Fehlerstelle erfassen zu können, als dies bisher möglich ist (ungefähr 3 Kiloohm).

Es ist eine wohlbekannte Tatsache, daß Erdschlüsse, die nicht rechtzeitig lokalisiert und fortgeschaltet werden, zu Personenschäden oder zu Bränden führen können. Von besonderem Interesse sind hier sogenannte rückgespeiste Erdschlüsse, d. h. Fehler, bei denen eine Phase unterbrochen ist und ein Erdschluß in dieser Phase hinter der Unterbrechungsstelle auftritt, der über das Belastungsobjekt gespeist wird. Z. Zt. kann es lange dauern, bis diese Fehler entdeckt werden.

Ferner besteht der Wunsch nach Standardisierung der Relaisschutzvorrichtungen, so daß, unabhängig von der Größe des Netzes, der Erdung usw. dieselben Bauteile und Systeme für die verschiedenen Netze verwendet werden können.

Der Erfindung liegt die Aufgabe zugrunde, ein Verfahren der eingangs genannten Art nebst Durchführungsanordnung zu entwickeln, bei dem sich die Empfindlichkeit der Erdschlußstromschutzeinrichtung den jeweiligen Wünschen entsprechend leicht einstellen läßt und das für unterschiedliche Netze mit weitgehend gleichen Bauteilen aufgebaut werden kann.

Zur Lösung dieser Aufgabe wird ein Verfahren nach dem ersten Teil des Anspruches 1 vorgeschlagen, das erfindungsgemäß die im kennzeichnenden Teil des Anspruches 1 genannten Merkmale hat.

Vorteilhafte Weiterbildungen des Verfahrens nach der Erfindung sind in den Ansprüchen 2 bis 5 genannt.

Eine Anordnung zur Durchführung des Verfahrens ist gemäß der Erfindung durch die im Anspruch 6 genannten Merkmale gekennzeichnet.

Vorteilhafte Weiterbildungen der Anordnung sind in den Ansprüchen 7 bis 9 genannt.

Durch das Verfahren und die Durchführungsanordnung gemäß der Erfindung werden vor allem folgende Vorteile erreicht :

Erheblich höhere Ansprechempfindlichkeit für Erdschlüsse mit einem hohen Übergangswiderstand.

Ein einheitlicher und genereller Schutz, der für alle Netzarten paßt.

Der Bedarf an Stromtransformatoren ist mäßig, da systematische Abweichungen kompensiert werden.

In der Hochspannungsanlage werden Einsparungen erzielt, wie z. B. beim Nullpunktwiderstand, der nicht allzu leistungsfähig zu sein braucht.

Gute Wirtschaftlichkeit bei größeren Stationen.

Hohe Flexibilität hinsichtlich spezieller Funktionsforderungen.

Verbesserte Möglichkeiten zur automatischen Überwachung des Relaisschutzsystems. Dies kann so geschehen, daß sich die Meßeinrichtung selbst überwacht und daß mit einem besonderen Computer in gleichmäßigen Abständen sogenannte Routinetests in dem ganzen Relaissystem durchgeführt werden.

Die Anordnung kann ohne große Kosten leicht durch eine Automatik zur Wiedereinschaltung sowie durch eine Nullpunktautomatik vervollständigt werden.

Für die Messung von $I_J$ gibt es gemäß der Erfindung zwei Varianten. Bei der einen Variante (Meßverfahren 1) wird der Augenblickswert des Stromes zweimal pro Periode der Netzfrequenz gemessen, und zwar zu den Zeitpunkten, in denen die Nullpunktspannung 90° nach ihrem Nulldurchgang liegt, also in den Zeitpunkten, in denen die Wirkkomponente des Erdschlußstromes gerade ihren Spitzenwert hat. Dieses Meßverfahren 1 erfordert demzufolge einen Nullpunktwiderstand. Es ist im übrigen jedoch von dem Aufbau des Netzes unabhängig.

Bei der zweiten Variante (Meßverfahren 2) wird der Augenblickswert zu Zeitpunkten gemessen, die von einem Intervallzeitgeber bestimmt werden. Diese Variante erfordert im Prinzip keine Messung der Nullpunktspannung $U_o$, da eine Synchronisierung mit der Netzfrequenz mit Hilfe des Intervallzeitgebers geschieht. Auch stellt dieses Meßverfahren 2 keine Forderungen an den Nullpunktwiderstand, ganz gleich, ob ein solcher vorhanden ist oder nicht.

Die gleichzeitige Messung des Spitzenwertes der Erdschlußwirkströme sämtlicher Leitungen beziehungsweise die durch den Intervallzeitgeber gesteuerten Augenblickswertmessungen werden dank der Verwendung eines mehrkanaligen sogenannten multiplexierten Analog-Digitalwandlers, d. h. eines sehr schnellen Signalwandlers mit analogem Eingang und digitalem Ausgang ermöglicht.

Aus der GB-A-2 008 345 ist eine Anordnung bekannt zur Überwachung der Ströme in einer mehrphasigen Leitung. Dabei werden die Strommeßwerte multiplexiert abgebildet, und durch Auswerteschaltungen werden Überströme, Schieflasten, Kurzschlüsse und Erdschlüsse auf der Leitung ermittelt, wobei grundsätzlich die Wechselstromgrößen zunächst in Gleichstromgrößen umgewandelt werden. Lediglich für die Messung des Erdschlußstroms wird eine Summenmessung der multiplexiert abgebildeten Wechselgrößen der gemessenen Phasenströme vorgenommen, wobei der Summenwert mit einem Bezugswert verglichen wird.

Anhand der in den Figuren gezeigten Ausführungsbeispiele von Anordnungen zur Durchführung des Verfahrens soll die Erfindung näher erläutert werden. Es zeigt :

Figur 1 ein Ausführungsbeispiel für eine Anordnung zur Durchführung des Meßverfahrens 1, bei dem man nur den Spitzenwert der Erdschluß stromkomponente ausnutzt, die in Phase mit der Nullpunktspannung liegt,

Figur 2 ein Ausführungsbeispiel einer Anordnung zur Durchführung des Meßverfahrens 2, bei dem man sowohl den Erdschlußstrom als auch die Änderungen des Erdschlußstromes zur Überwachung heranzieht und bei dem man denjenigen der Ströme, der zuerst einen für jeden derselben vorgegebenen Sollwert erreicht, ein Auslösungssignal verursachen läßt.

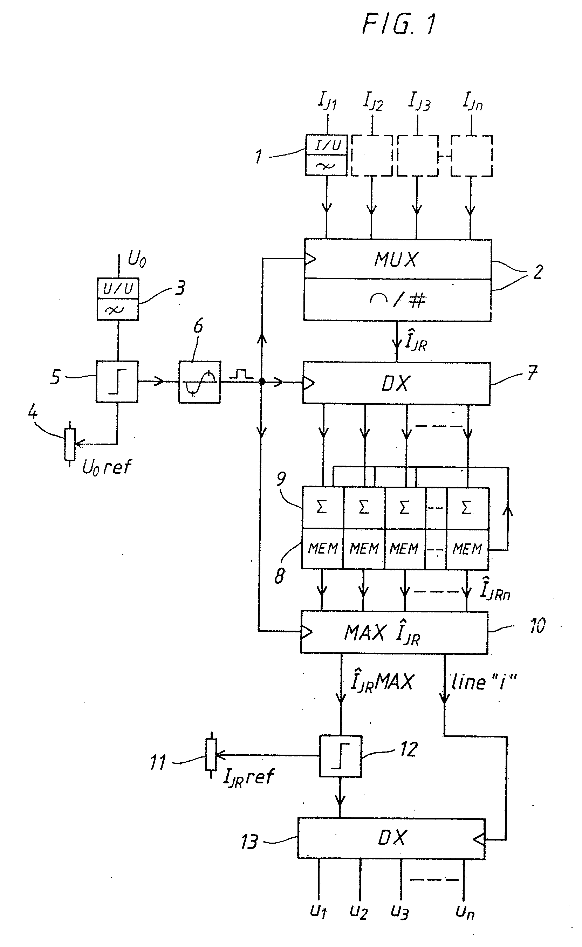

In dem Ausführungsbeispiel gemäß Fig. 1 sind die Erdschlußströme sämtlicher Leitungen, welche normalerweise praktisch Null sind, in Form der Stromsignale $I_{J1}$, $I_{J2}$ usw. verfügbar. Jedes dieser Stromsignale wird in einem zugeordneten Anpassungsglied 1 in ein geeignetes Spannungssignal umgeformt. In den Anpassungsgliedern 1 findet auch die Filterung statt. Die Ausgänge der Anpassungsglieder sind an je einen Eingang eines multiplexierten Analog-Digitalwandlers 2 angeschlossen. Zu der Anordnung gehört auch ein Meßglied 3 für die Nullpunktspannung $U_0$. Wenn diese einen an einem Sollwertsteller 4 eingestellten Sollwert $U_0$ref übersteigt, so gibt das Schwellwertglied 5 den Weg für die Nullpunktspannung $U_0$ an das Steuerimpulsglied 6 des Analog-Digitalwandlers 2 frei. Das Steuerimpulsglied 6 liefert jedesmal dann einen Startimpuls an den multiplexierten A/D-Wandler, wenn die Nullpunktspannung $U_0$ ein Maximum passiert. In diesem Zeitpunkt werden die Augenblickswerte sämtlicher Leitungsströme gemessen. In diesem Zeitpunkt hat die Komponente der Erdschlußstromes, die mit der Nullpunktspannung in Phase liegt, ihren Spitzenwert. Der multiplexierte A/D-Wandler liefert einen digitalen Wert für jede Leitung, der dem Stromsignal $I_{JR}$ entspricht.

Diese Werte werden einem Demultiplexierer 7 zugeführt, der ebenfalls vom Steuerimpulsglied 6 gesteuert wird. Jeder Leitung ist ein Speicher 8 zugeordnet, dem der entsprechende Meßwert zugeführt und in dem er gespeichert wird. Mit jedem neuen Startimpuls vom Steuerimpulsglied 6, d. h. also jedesmal, wenn die Nullpunktspannung $U_0$ einen Höchstwert passiert, wird für jede Leitung eine neue Messung des Stromsignals $I_{JR}$ vorgenommen. Der digitale Wert wird in einem Summierungsglied 9 zu dem Wert summiert, der in dem betreffenden Speicher 8 gespeichert ist. Im Takt mit der Impulsabgabe durch das Steuerimpulsglied 6 werden sämtliche Speicher von einem Maximalwertsucher 10 abgesucht. Der Maximalwertsucher stellt fest, welches seiner mehreren Eingangssignale am größten ist. Der Maximalwertsucher hat zwei Ausgänge, von denen der eine den herausgesuchten Maximalwert abgibt, während der andere angibt, auf welcher der Eingangsleitungen dieser Maximalwert auftritt. Der vom Maximalwertsucher abgegebene maximale summierte Wert (Stromwert) wird mit einem am Sollwertsteller 11 eingestellten Sollwert $I_{JR}$ref verglichen. Wenn der vom Maximalwertsucher gelieferte Stromwert größer als der Sollwert $I_{JR}$ref ist, so gelangt ein Signal an einen Demultiplexierer 13. Der Demultiplexierer 13 wird von der Leitungsinformation am anderen Ausgang des Maximalwertsuchers 10 gesteuert, so daß für diejenige Leitung, deren Erdschlußstrom so groß ist, daß das entsprechende Signal das Schwellwertglied 12 passiert, ein Auslösesignal u geliefert wird.

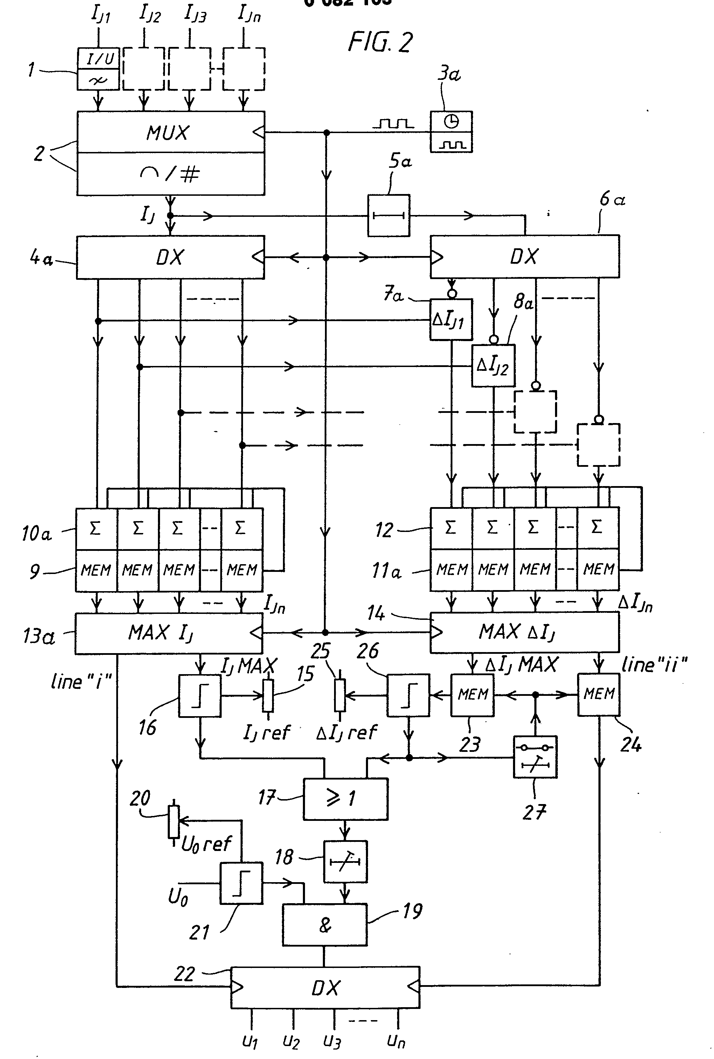

Figur 2 zeigt eine Ausführungsform der Erfindung, anhand welcher das Prinzip des zweiten Meßverfahrens gemäß der Erfindung beschrieben werden soll. Die Erdschlußströme sämtlicher Leitungen sind wieder in Form der Stromsignale $I_{J1}$, $I_{J2}$ usw. verfügbar. Jedem dieser Stromsignale ist ein Anpassungsglied 1 zugeordnet, welches das Stromsignal in ein geeignetes Spannungssignal umformt und in welchem auch die Filterung erfolgt. Die Ausgänge der Anpassungsglieder 1 sind an einen multiplexierten Analog-Digitalwandler 2 angeschlossen. Zu der Anordnung gehört auch ein Intervallzeitgeber 3a (Taktglied). Der Intervallzeitgeber 3a erzeugt eine feste Anzahl Startimpulse pro Periode für den multiplexierten A/D-Wandler. Die Startimpulse haben gleiche Abstände, und der n-te Impuls in einer Periode hat in der nächsten Periode wieder dieselbe Phasenlage relativ zu dem speisenden Netz. Jeder momentan für jede Leitung gemessene und in einen digitalen Wert umgewandelte Wert wird einerseits direkt einem Demultiplexierer 4a und andererseits über ein Verzögerungsglied 5a mit einer Zeitverzögerung von einer Periode einem anderen Demultiplexierer 6a zugeführt. Die Demultiplexierer 4a und 6a werden von dem Intervallzeitgeber 3a mit denselben Startimpulsen wie der multiplexierte Analog-Digitalwandler 2 gesteuert. Den Unterschied zwischen dem gemessenen Augenblickswert auf jeder Leitung und dem entsprechenden Wert vor einer Periode erhält man mit Hilfe der Subtraktionsglieder 7a, 8a usw. für sämtliche Leitungen. Die vom Demultiplexierer 4a gelieferten Werte werden einem Speicher 9 zugeführt. Mit jedem Startimpuls vom Intervallzeitgeber 3a kommt für jede Leitung ein neuer Meßwert hinzu. Eine Summierung der Meßwerte pro Periode erhält man durch die Summierungsglieder 10a. Der für jede Periode erhaltene Wert stellt ein Maß für den Erdschlußstrom während dieser Periode dar. Für jede Periode werden die Speicher erneut auf Null gestellt. In gleicher Weise wird mit den Werten verfahren, welche die Stromänderungen darstellen, d. h. mit den Ausgangssignalen der Subtraktionsglieder 7a, 8a usw., die dem Speicher 11a über die sie verarbeitenden Summierungsglieder 12 zugeführt werden. Der einzige Unterschied besteht darin, daß die Änderung des Erdschlußstroms $\Delta I_J$ als Summe der Beträge der für jede Messung erhaltenen einzelnen Differenzen des Erdschlußstroms während zweier Perioden der Netzfrequenz gebildet wird. Von den Maximalwertsuchern 13a und 14, die auch von dem Intervallzeitgeber 3a gesteuert werden, werden sämtliche Werte abgesucht, und an den Ausgängen der Maximalwertsucher erhält man eine Information darüber, welche Leitung (line « i ») den größten Erdschlußstrom $I_J$ hat und wie groß dieser Strom ist, bzw. darüber, welche Leitung (line « ii ») die größte Stromänderung $I_J$ aufweist und wie groß diese Änderung ist. Der Stromwert $I_J$MAX wird mit einem Sollwert $I_J$ref vom Sollwertsteller 15 verglichen. Das Schwellwertglied 16 gibt ein Signal an das ODER-Glied 17, wenn $I_J$MAX > $I_J$ref ist. Der Ausgang des ODER-Gliedes 17 wird über ein einstellbares Zeitverzögerungsglied 18 an ein UND-Glied 19 angeschlossen. Das andere Kriterium für die Freigabe eines Auslösesignals u besteht darin, daß die Nullpunktspannung einen am Sollwertsteller 20 eingestellten Sollwert $U_o$ref übersteigt. Das Schwellwertglied 21 gibt ein Signal an das UND-Glied 19, wenn $U_o$ > $U_o$ref ist. Der Ausgang des UND-Gliedes 19 ist an den Demultiplexierer 22 angeschlossen, der mit Hilfe der Leitungsinformation line « i » ein Auslösesignal u an die fehlerhafte Leitung gibt. Die Ausgangssignale des Maximalwertsuchers 14 werden ihren zugeordneten Speichern 23 und 24 zugeführt. Diese Speicher werden nullgestellt und bei jedem Suchen des Maximalwertsuchers kontinuierlich eingestellt. Das Ausgangssignal des Speichers 23, das $\Delta I_J$MAX entspricht, wird mit einem am Sollwertsteller 25 eingestellten Sollwert $\Delta I_J$ref verglichen, und wenn $\Delta I_J$MAX > $\Delta I_J$ref ist, gibt das Schwellwertglied 26 ein Ausgangssignal, das als zweites Eingangssignal dem ODER-Glied 17 zugeführt wird. Das Ausgangssignal des Schwellwertgliedes 26 wird auch einem Sperrglied 27 zugeführt, das, wenn es ein Signal erhält, die Speicher 23 und 24 für eine gewisse Zeitspanne blockiert. Diese Maßnahme ist erforderlich, um sicherzustellen, daß die Information vom Maximalwertsucher 14 nach der vom Verzögerungsglied 18 verursachten Zeitverzögerung noch vorhanden ist. Die Leitungsinformation (line « ii ») zur Steuerung der Auslösefunktion an die richtige Leitung ist dann noch vorhanden und wird dem Demultiplexierer 22 zugeführt.

## Patentansprüche

1. Verfahren zum Erfassen von Erdschlüssen in einem elektrischen Energieverteilungsnetz, in welchem mehrere zu dem Netz gehörende Leitungen von einer Station ausgehen, wobei der Erdschlußstrom ($I_J$) für jede dieser Leitungen gemessen wird, dadurch gekennzeichnet, daß diejenige Leitung ausgewählt wird, die den größten Erdschlußwirkstrom ($I_{JR}$), den größten Erdschlußstrom ($I_J$) oder die größte Änderung des Erdschlußstroms ($\Delta I_J$) aufweist, und daß der gemessene Erdschlußwirkstrom oder der gemessene Erdschlußstrom oder die gemessene Änderung des Erdschlußstroms der ausgewählten Leitung mit mindestens einem vorgegebenen Sollwert verglichen wird, wobei ein Fehleranzeigesignal gegeben wird, wenn die genannte Vergleichsgröße den Sollwert übersteigt.

2. Verfahren nach Anspruch 1, dadurch gekennzeichnet, daß für jede Leitung der Augenblickswert des Erdschlußwirkstroms ($I_{JR}$) in den Zeitpunkten gemessen wird, in denen der Differentialquotient der Nullpunktspannung durch Null geht, und daß ein Maß für den Betrag der Wirkkomponente der Erdschlußströme dadurch gewonnen wird, daß die gemessenen Werte für jede Leitung summiert werden.

3. Verfahren nach Anspruch 1, dadurch gekennzeichnet, daß der Augenblickswert des Erdschlußstroms ($I_J$) zu mehreren Zeitpunkten während jeder Periode der Netzfrequenz gemessen wird und daß ein Maß für den Betrag der Erdschlußströme ($I_J$) dadurch gewonnen wird, daß eine bestimmte Anzahl der gemessenen Werte für jede Leitung über die Zeit summiert wird.

4. Verfahren nach Anspruch 3, dadurch gekennzeichnet, daß für jede Leitung die Differenz aus den während einer Periode gemessenen Werten des Erdschlußstroms ($I_J$) und den entsprechenden in der vorausgegangenen Periode gemessenen Werten kontinuierlich gebildet wird und daß die Beträge sämtlicher für zwei Perioden der Netzfrequenz gewonnener Differenzwerte des Erdschlußstroms ($I_J$) addiert werden, wobei dieser Summenwert als Maß für die Änderung des Erdschlußstroms ($\Delta I_J$) dient.

5. Verfahren nach einem der vorhergehenden Ansprüche, dadurch gekennzeichnet, daß die für jede Leitung erfolgende Messung des Erdschlußstroms ($I_{JR}$) eingeleitet und solange fortgesetzt wird, bis die gemessene Nullpunktspannung ($U_o$) des Netzes einen vorgegebenen Wert erreicht.

6. Anordnung zur Durchführung des Verfahrens nach einem der vorangegangenen Ansprüche mit Geräten zur Messung des Erdschlußstromes ($I_J$) für jede der von der Station ausgehenden Leitung, dadurch gekennzeichnet, daß Geräte (10, 13a, 14) vorhanden sind zum Auswählen derjenigen Leitung, die den größten Erdschlußwirkstrom ($I_{JR}$), den größten Erdschlußstrom ($I_J$) oder die größte Änderung des Erdschlußstroms ($\Delta I_J$) aufweist, daß Geräte (12, 16, 26) zum Vergleich des gemessenen Erdschlußwirkstroms, des gemessenen Erdschlußstroms oder der gemessenen Änderung des Erdschlußstroms mit mindestens einem vorgegebenen Sollwert vorhanden sind und daß Geräte (13, 22) zum Abgeben eines Fehleranzeigesignals vorhanden sind, wenn die genannte Vergleichsgröße den Sollwert übersteigt.

7. Anordnung nach Anspruch 6, dadurch gekennzeichnet, daß für jede Leitung ein Anpassungsglied (1) vorhanden ist, an dessen Eingang der Meßwert des Erdschlußstromes $I_J$ der betreffenden Leitung angeschlossen ist, daß der Ausgang jedes Anpassungsgliedes (1) an eine Meßeinrichtung für den Erdschlußstrom ($I_J$) angeschlossen ist, welche einen für jede Leitung eingerichteten Ausgang hat, an denen fehleranzeigende Ausgangssignale auftreten.

8. Anordnung nach Anspruch 7, dadurch gekennzeichnet, daß eine Meßeinrichtung (3, 5, 6) für die Nullpunktspannung ($U_o$) vorhanden ist, an deren Eingang die Nullpunktspannung anliegt und an deren Ausgang ein Ausgangssignal abgegeben wird, wenn der Differentialquotient der Nullpunktspannung durch Null geht und gleichzeitig die Amplitude der Nullpunktspannung einen vorgegebenen Wert überschreitet.

9. Anordnung nach einem der Ansprüche 6 bis 8, dadurch gekennzeichnet, daß die genannte Meßeinrichtung für den Erdschlußstrom ($I_J$) so beschaffen ist, daß sowohl die Änderung des Erdschlußstromes ($\Delta I_J$) als auch der absolute Wert des Erdschlußstromes oder die Wirkkomponente desselben erfaßt werden, und daß bei einem einen vorgegebenen Sollwert übersteigenden Wert ein fehleranzeigendes Ausgangssignal auftritt.

## Claims

1. Method for detecting ground faults in an electric power distributing network with several lines of said network originating from one station, whereby the ground fault current ($I_J$) is sensed for each of said lines, characterized in that that line is selected which shows the greatest active ground fault current ($I_{JR}$), the greatest ground fault current ($I_J$), or the greatest change of the ground fault current ($\Delta I_J$), and that the measured active ground fault current, or the measured ground fault current, or the measured change of the ground fault current of said selected line is compared with at least one predetermined reference value, whereby a fault indication signal is delivered when said comparison quantity exceeds said reference value.

2. Method according to claim 1, characterized in that the instantaneous value of the active ground fault current ($I_{JR}$) is measured for each line at the times in which the differential function of the neutral point voltage is passing zero, and that a measure for the absolute value of the active component of the ground fault current is obtained by summing up the measured values for each line.

3. Method according to claim 1, characterized in that the instantaneous value of the ground fault current ($I_J$) is measured at several times during each cycle of the power frequency, and that a measure for the absolute values of the ground fault currents ($I_J$) is obtained by summing up a specified number of consecutively measured values for each line.

4. Method according to claim 3, characterized in that during one cycle the difference between the measured values of the ground fault current ($I_J$) and the corresponding values measured during the preceding cycle are continuously formed for each line, and that the absolute values of all difference values of the ground fault current ($I_J$) formed during two cycles of the power frequency are added, the value of this sum serving as a measure for the changes of the ground fault current ($\Delta I_J$).

5. Method according to any of the preceding claims, characterized in that the measuring of the ground fault current ($I_J$) for each line is initiated and continued until the measured neutral point voltage ($U_o$) of the network arrives at a predetermined value.

6. Arrangement for carrying out the method according to any of the preceding claims including devices for measuring the ground fault current ($I_J$) for each line originating from said station, characterized in that there are devices (10, 13a, 14) to select that line which shows the greatest active ground fault current ($I_{JR}$), the greatest ground fault current ($I_J$), or the greatest change of the ground fault current ($\Delta I_J$), that there are devices (12, 16, 26) to compare the measured active ground fault current ($I_J$), the measured ground fault current ($I_J$), or the measured change of the ground fault current with at least one predetermined reference value, and that there are devices (13, 22) to deliver a fault indication signal when said comparison quantity exceeds said reference value.

7. Arrangement according to claim 6, characterized in that there is an interface unit (1) for each line, arranged to receive at its input the measuring value of the ground fault current ($I_J$) of the respective line, that the output of each interface unit (1) is connected to a measuring unit for the ground fault current ($I_J$) having an output for each line, which outputs deliver fault-indicating output signals.

8. Arrangement according to claim 7, characterized in that there is a measuring unit (3, 5, 6) for the neutral point voltage ($U_o$), the input of which receives the neutral point voltage and the output of which is arranged to deliver an output signal when the differential function of the neutral point voltage passes zero and at the same time the amplitude of the neutral point voltage exceeds a predetermined value.

9. Arrangement according to any of claim 6 to 8, characterized in that said measuring unit for the ground fault current ($I_J$) is arranged to measure both the change in the ground fault current ($\Delta I_J$) and the absolute value of the ground fault current ($I_J$) or its active component, and that a fault-indicating output signal is delivered when the measured value exceeds a predetermined reference value.

## Revendications

1. Procédé pour saisir des mises à la terre dans des réseaux de distribution de l'énergie électrique, dans lequel plusieurs conducteurs appartenant au réseau partent d'un poste de distribution, le courant de perte à la terre ($I_J$) étant mesuré pour chacun de ces conducteurs, caractérisé par le fait que l'on choisit le conducteur qui présente le plus grand courant actif de perte à la terre ($I_{JR}$), le plus grand courant de perte à la terre ($I_J$) ou la plus grande modification du courant de perte à la terre ($\Delta I_J$), et le courant actif de perte à la terre mesuré ou le courant de perte à la terre mesuré ou la modification mesurée du courant de perte à la terre du conducteur choisi est comparé avec au moins une valeur de consigne prédéterminée, un signal de départ étant fourni lorsque ladite grandeur de comparaison dépasse la valeur de consigne.

2. Procédé selon la revendication 1, caractérisé par le fait que pour chaque conducteur, on mesure la valeur instantanée du courant de perte à la terre ($I_{JR}$) aux instants auxquels le quotient différentiel de la tension neutre-terre passe par la valeur zéro, et que l'on obtient une mesure pour la valeur des composantes actives des courants de perte à la terre par addition des valeurs mesurées pour chaque conducteur.

3. Procédé selon la revendication 1, caractérisé par le fait que la valeur instantanée du courant de perte à la terre ($I_J$) est mesurée à plusieurs instants pendant une période de la fréquence du réseau, et que l'on obtient une mesure pour la valeur des courants de perte à la terre ($I_J$) en additionnant sur le temps un nombre déterminé des valeurs de mesure pour chaque conducteur.

4. Procédé selon la revendication 3, caractérisé par le fait que pour chaque conducteur, on forme de façon continue la différence entre les valeurs du courant de perte à la terre ($I_J$) mesurées pendant une période et les valeurs correspondantes mesurées pendant la période précédente, et que l'on additionne toutes les valeurs différentielles du courant de perte à la terre ($I_J$) obtenues pour deux périodes de la fréquence du réseau, cette valeur de sommation servant de mesure pour la modification du courant de perte à la terre.

5. Procédé selon l'une des revendications précédentes, caractérisé par le fait que la mesure du courant de perte à la terre ($I_{JR}$) opérée pour chaque conducteur, débute et est poursuivie jusqu'à ce que la tension neutre terre ($U_o$) du réseau atteint une valeur prédéterminée.

6. Dispositif pour la mise en œuvre du procédé selon l'une des revendications précédentes, avec des appareils servant à mesurer le courant de perte à la terre ($I_J$) pour chacun des conducteurs partant du poste de distribution, caractérisé par le fait qu'il comporte des appareils (10, 13a, 14) pour choisir celui des conducteurs présentant le plus grand courant actif de perte à la terre ($I_{JR}$), le plus grand courant de perte à la terre ($I_J$) ou la plus grande modification du courant de perte à la terre ($\Delta I_J$), que sont prévus des appareils (12, 16, 26) servant à comparer le courant actif de perte à la terre mesuré, du courant de perte à la terre mesuré ou de la modification mesurée du courant de perte à la terre avec au moins une valeur de consigne prédéterminée, ainsi que des appareils (13, 22) pour émettre un signal de défaut lorsque ladite grandeur de comparaison dépasse la valeur de consigne.

7. Dispositif selon la revendication 6, caractérisé par le fait que pour chaque conducteur est prévu un élément d'adaptation (1) à l'entrée duquel est appliquée la valeur mesurée du courant de perte à la terre ($I_J$) du conducteur concerné, que la sortie de chaque élément d'adaptation (1) est reliée à un dispositif de mesure pour le courant de perte à la terre ($I_J$), qui possède une sortie agencée pour chaque conducteur, sorties au niveau desquelles apparaissent des signaux de sortie qui indiquent un défaut.

8. Dispositif selon la revendication 7, caractérisé par le fait qu'il est prévu un dispositif de mesure (3, 5, 6) pour la tension neutre-terre ($U_o$) à l'entrée duquel est présente la tension neutre-terre et à la sortie duquel est émis un signal de sortie lorsque le quotient différerntiel de la tension neutre-terre passe par la valeur zéro et qu'en même temps l'amplitude de la tension neutre-terre dépasse une valeur prédéterminée.

9. Dispositif selon l'une des revendications 6 à 8, caractérisé par le fait que ledit dispositif de mesure pour le courant de perte à la terre ($I_J$) est constitué de telle manière que sont saisies aussi bien la modification du courant de perte à la terre ($\Delta I_J$) que la valeur absolue du courant de perte à la terre ou la composante active de ce dernier, et que pour une valeur qui dépasse une valeur de consigne prédéterminée, apparaît un signal de sortie indiquant un défaut.

*FIG. 1*

0 082 103

FIG. 2

0 082 103